Europäisches Patentamt

European Patent Office

Office européen des brevets

(19)

(11) **EP 1 717 983 A1**

(12) **EUROPEAN PATENT APPLICATION**

(43) Date of publication:
**02.11.2006 Bulletin 2006/44**

(51) Int Cl.:
*H04L 1/00* (2006.01)    *H03M 13/37* (2006.01)

(21) Application number: **06250632.4**

(22) Date of filing: **06.02.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **26.04.2005 US 114023**

(71) Applicant: **Agere Systems, Inc.**
**Allentown, PA 18109 (US)**

(72) Inventors:
 • **Ridler, Oliver**
  **Thornleigh 2120 (AU)**
 • **Widdup, Benjamin John**
  **Glenwood 2768 (AU)**
 • **Woodward, Graeme Kenneth**
  **Epping 2121 (AU)**

(74) Representative: **Williams, David John et al**
 **Page White & Farrer**
 **Bedford House**
 **John Street**
 **London, WC1N 2BF (GB)**

(54) **Selection of 1-out-of-n scrambled code blocks**

(57) Apparatus and method to determine selection of a scrambled data channel before receipt of an entire data block. An initial portion of a block of data received in one of a plurality of scrambled data channels is decoded, then re-encoded. A value is computed related to the number of mis-matched data symbols based on a comparison of decoded/re-encoded data and the corresponding received data. A best one of the plurality of data channels is selected based on the computed value being beyond a given threshold value.

**EP 1 717 983 A1**

**Description**

**BACKGROUND OF THE INVENTION**

**1. Field of the Invention**

The present invention relates to interpretation of data before a complete data block is received and a cyclic redundancy check (CRC) is available. More specifically, it relates to detection and selection of a scrambled control channel from among a plurality of control channels in a transmission before the complete data block is received and error checked.

**2. Background of Related Art**

Terminal equipment (handsets) designed to be compatible with the HSDPA extensions in release 5 of the Third Generation Partnership Project ("3GPP") UMTS standards must be able to receive up to four High-Speed Downlink Packet Access (HSDPA) control channels (called High-Speed Shared Control Channels (HS-SCCHs)) and select zero or one for further processing. (The 3GPP standard is available at www.3gpp.org) The selection of one of the received HS-SCCHs is not trivial because no embedded identification ("ID") or cyclic redundancy check ("CRC") is available at the time the selection must take place. The invention provides a method for making this selection.

This is a relatively new problem since it appears only since release 5 of the 3GPP standard.

During the course of standardization, numerous submissions were made to standards body (i.e., 3GPP) meetings. Most notably, the performance of different metrics was discussed and compared in submissions from Motorola [1] and Lucent [2][3] (references cited below). Further analysis was provided in the academic literature [4][5]. The methods proposed included the Yamamoto-Itoh metric and the squared Euclidean distance metric directly from the Viterbi decoder.

This problem also shares similarities with blind transport format detection (BTFD) for which there is some prior art [6][7][8].

[1] 3GPP TSG-RAN WG1#24, R1-02-0610, "Performance of the HS-SCCH", Motorola, April 2002.

[2] 3GPP TSG-RAN WG1#25, R1-02-0553, "Way forward on HS-SCCH coding", Lucent Technologies, April 2002.

[3] 3GPP TSG-RAN WG1#25, R1-02-0649, "Performance of the HS-SCCH", Lucent Technologies, April 2002.

[4] Ghosh, Ratasuk, Frank, Love, Stewart, Buckley [Motorola], "Control Channel Design for High Speed Downlink Shared Channel for 3GPP W-CDMA, Rel-5", Vehicular Technology Conference 2003 (VTC '03), April 2003, Jeju Korea.

[5] Das, Gopalakrishnan, Hu, Khan, Rudrapatna, Sampath, Su, Tatesh, Zhang [Lucent], "Evolution of UMTS Toward High-Speed Downlink Packet Access", Bell Labs Technical Journal, Vol. 7, Issue 3, pp47-68, 2003.

[6] Berns, F.; Kreiselmaier, G.; When, N., "Channel decoder architecture for 3G mobile wireless terminals", Design, Automation and Test in Europe Conference and Exhibition, 2004. Proceedings, pp192-197, 16-20 Feb. 2004.

[7] Ahmed, W.K.M.; Balachandran, K., "Methods for estimation of the uncoded symbol error rate at the receiver", Global Telecommunications Conference, 2002. GLOBECOM '02. IEEE, pp1334-1338, 17-21 Nov. 2002.

[8] Raghavan, A.R.; Baum, C.W., "A reliability output Viterbi algorithm with applications to hybrid ARQ", IEEE Trans.Information Theory, Vol. 44, No. 3, pp1214-1216, May 1998

The recommendation of the standards submissions [1]-[5] concluded that the Yamamoto-Itoh or Squared Euclidean distance metrics should be used to select the HS-SCCH for further processing. The Yamamoto-Itoh metric involves substantial changes to the internals of the Viterbi decoder. Consequently, a generic Viterbi decoder design must be modified and the complexity increased. Using the squared Euclidean metric of the maximum likelihood path through the trellis (the final zero state metric at the conclusion of Viterbi decoding for a properly terminated codeblock), was found to give inferior performance.

Much of the prior art for BTFD is limited by the inability to independently discriminate between correctly and incorrectly decoded data, relying upon analysis of a CRC in the data block. The CRC in the HS-SCCH is not available early enough to be useful [6] [7]. Some methods [6][8] also need accurate channel knowledge, which is unlikely to be available in this case.

There is a need for methods and apparatus for better detecting and selecting one (or no) HS-SCCH from a transmission containing a plurality of HS-SCCHs, before the data block is completely received.

**SUMMARY OF THE INVENTION**

In accordance with the principles of the present invention, apparatus to select one of a plurality of scrambled data channels before receipt of an entire data block comprises a decode module to decode an input symbol from one of the plurality of scrambled data channels. A re-encode module re-encodes decoded symbols output from the decode module. A comparison module compares aspects of a received symbol with a corresponding aspect of the decoded/re-encoded symbol and accumulates those aspects. A decision module selects a best one of the plurality of scrambled data channels based on an accumulated output of the comparison module.

In accordance with another aspect of the present invention, a method of computing a metric to determine selection of a scrambled data channel before receipt of an entire data block comprises descrambling and decoding an initial portion of a block of data received in one of a plurality of data channels. The initial portion of the block of data is re-encoded. A value is computed by accumulating the magnitudes of mis-matched data samples based on a comparison of decoded/re-encoded data and the corresponding received and descrambled data. A best one of the plurality of data channels is selected based on the computed value being better than the other channels and possibly also beyond a given threshold value.

**BRIEF DESCRIPTION OF THE DRAWINGS**

Features and advantages of the present invention will become apparent to those skilled in the art from the following description with reference to the drawings, in which:

Fig. 1 shows an exemplary block diagram of an embodiment of a circuit to compute a metric to determine selection of a scrambled data channel before receipt of an entire block, in accordance with the principles of the present invention.

Fig. 2 shows an exemplary method of computing a metric to determine selection of a scrambled data channel before receipt of an entire block, in accordance with the principles of the present invention.

Fig. 3 shows an exemplary frame error rate performance of a decoder for Part 1 of the HS-SCCH, in accordance with the principles of the present invention.

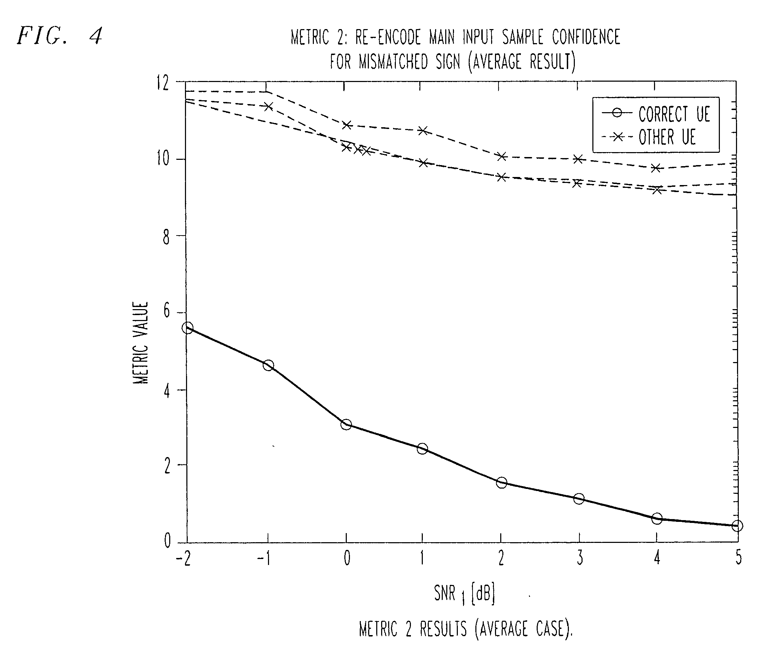

Fig. 4 shows an average case for results of the proposed metric (referred to as "metric 2"), demonstrating reliability at differentiating between the correct HS-SCCH and an HS-SCCH belonging to another user.

Fig. 5 shows the confirmation of reliability of techniques using metric 2, by measuring how reliably metric based selection chooses the correct block.

Fig. 6 shows a probability density function for metric 2 with a 1 dB signal-to-noise ratio (SNR).

**DETAILED DESCRIPTION OF ILLUSTRATIVE EMBODIMENTS**

The inventive technique allows similar or superior performance to methods described previously, with lower complexity, and without the need for accurate channel parameters or separate CRC checks.

Terminal equipment (handsets) designed to be compatible with the HSDPA extensions in release 5 of the 3GPP UMTS standards must be able to receive up to 4 HSDPA control channels (called HS-SCCHs) and select zero or one for further processing. The selection of one of the received HS-SCCHs is not trivial because no embedded ID or CRC is available at the time the selection must take place. The invention provides a method for making this selection.

According to release 5 of the 3GPP UMTS standards, user equipment (UE) must be able to receive up to 4 HSDPA control channels (called HS-SCCHs). Unless significant buffering is permitted, the UE must be able to select zero or one HS-SCCH channel for further processing by observing only Part 1 of the HS-SCCH transmission. The selection of one of the received HS-SCCHs is not trivial because no embedded ID or CRC is available at the time the selection must take place. (A CRC is available at a later time to verify correct receipt of the HS-SCCH, however this is not relevant information in the current instance because the HS-SCCH contains information necessary to configure the receiver, which starts receiving the main HSDPA data channel(s) before the CRC is transmitted. Therefore the correct HS-SCCH must be selected before the CRC is available. Thus the CRC cannot be used as a criterion in the selection process.)

HS-SCCH data is scrambled before transmission, the scrambling mask being dependant upon the destination handset's ID number, and is broadcast to multiple handsets within the cell. A handset will receive up to 4 scrambled HS-SCCHs in a transmission time interval (TTI), however at most one (and possibly zero) are intended for any one handset. The handset descrambles the received data (according to its own ID) and then decodes the (up to 4) blocks. Only correctly descrambled data can be correctly received, however due to noise in the transmission channel it is difficult to determine which block, if any, is intended for the handset in question.

A new metric is proposed and used to facilitate the HS-SCCH selection process. It is important that the metric is reliable for short block lengths (for the 3GPP HSDPA application, the block length is just 8 bits).

In accordance with the principles of the present invention, for part 1 of each received HS_SCCH channel:

Step 1.1: Descramble received data (according to own ID)
Step 1.2: Decode received data
Step 1.3: Re-encode decoder output
Step 1.4: Compute the following metric:

$$M = \sum_{\substack{received \\ symbols}} y_i$$

where: $y_i=0$ when *sign(received_sample)*=sign(re-encoded_bit);

$y_i$= absolute_value(*received_sample*) otherwise.

Step 2: Select the best HS-SCCH channel, i.e., that with the minimum metric from Step 1.4.

Once an HS-SCCH is selected, it is necessary to decide whether to continue processing the channel (it corresponds to the UE in question), or to discard the transmission entirely (no HS-SCCH intended for the UE in question). A threshold can be applied to the metric to aid this decision. In a given embodiment, such threshold may be determined empirically.

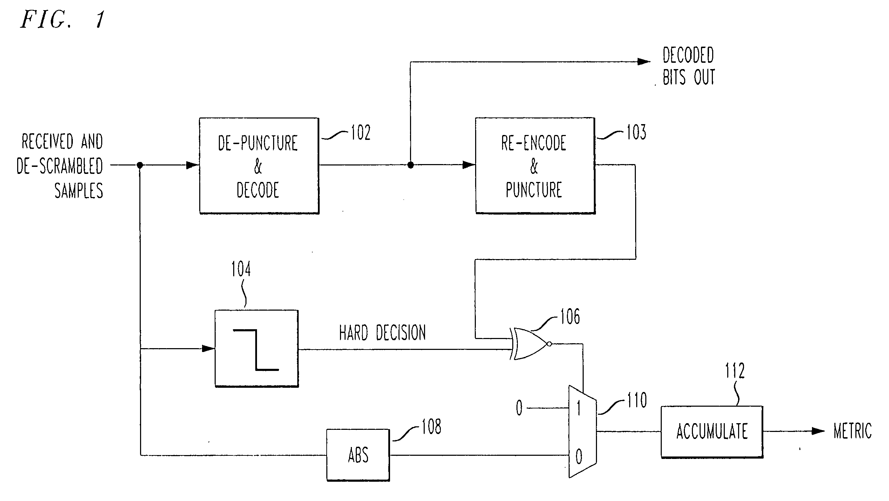

Fig. 1 shows an exemplary block diagram of an embodiment of a circuit to compute a metric to determine selection of a scrambled data channel before receipt of an entire block, in accordance with the principles of the present invention.

In particular, as shown in Fig. 1, samples of an input signal are received and descrambled. Each symbol of the descrambled signal are input to a decode block **102.**

The decode block **102** shown in the disclosed embodiment shows an additional function of de-puncturing. Puncturing is a technique that allows the encoding and decoding of higher rate codes using standard fixed rate (e.g. rate 1/3) encoders and decoders. A Puncture block removes bits from an encoded bit stream, thereby increasing the code rate. While shown with de-puncturing, the principles of the present invention are equally applicable to embodiments not requiring and/or including puncturing/de-puncturing.

The decoded bits output from the decode block **102** may be utilized by the relevant equipment (e.g., mobile phone) in any otherwise conventional manner. However, in accordance with the principles of the present invention, the output of the decode block **102** is also fed into a Re-encode block **103.** The re-encode block **103** in the disclosed embodiments includes a puncture function complementary to the depuncture function present in the decode block **102.**

A time delayed version of the received samples is fed into the metric calculation blocks, **104, 106, 110, 108, 112.** Blocks **104, 106** are intended to determine if the decoded and re-encoded samples output from the re-encode block **103** is of the same sign as the original symbol input to the decode block **102.** Blocks 108, 110, 112 are intended to compute the value of the metric, the accumulation step 112 only taking place when the sign of the re-encoded sample does not match the sign of the received sample.

If the decoded data channel (e.g., a relevant one of the HS-SCCHs) is intended for the particular mobile device, the received samples will be largely the same as the decoded and re-encoded samples, and thus the sign of both samples will be the same. In such case, the accumulator **112** will accumulate a small value. If the decoded data channel is not intended for the particular mobile device, most likely more input samples will be of different sign, accumulating a larger value in the accumulator **112.**

In the disclosed embodiment, the metric calculation logic block includes a hard decision generator **104,** an XNOR gate **106,** an absolute value block **108,** a mulitplexer **110,** and an accumulator **112,** though other particular logic devices may be implemented within the principles of the present invention.

There are numerous other ways the inventive metric can be computed. For example, through generation of the code words and metric accumulation during the trace-back phase of the Viterbi decoding. This alternate means of calculation removes the need for a separate re-encode block, and may lead to lower latency; an important design consideration due to the need to immediately decode Part 2 of the HS-SCCH once the correct HS-SCCH channel has been selected (if any).

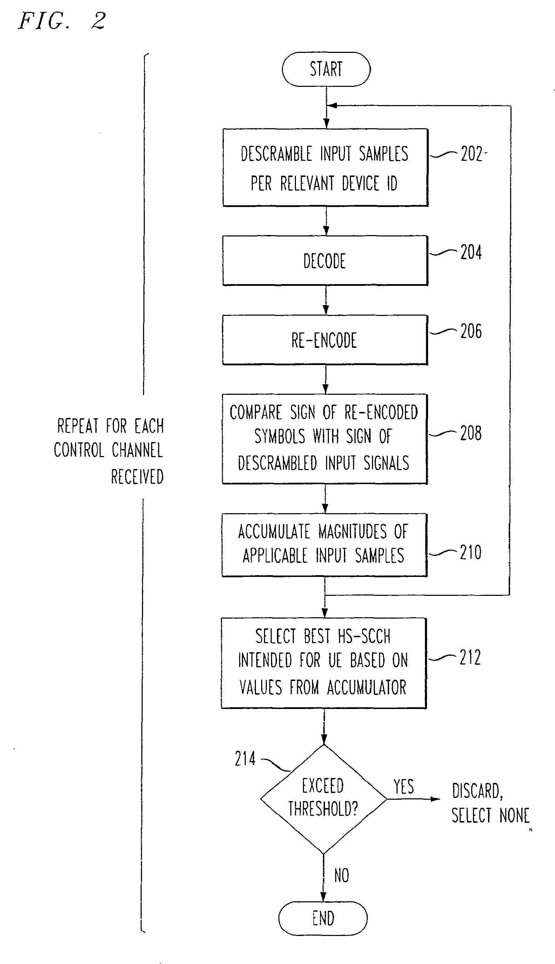

Fig. 2 shows an exemplary method of computing a metric to determine selection of a scrambled data channel before receipt of an entire block, in accordance with the principles of the present invention.

In particular, as shown in step **202** of Fig. 2, a sample of a data stream is input and descrambled per the device's descrambling code. In the disclosed embodiment, descrambling consists of changing the sign of selected samples in accordance with the device ID. In the disclosed embodiment, the data stream is one of a plurality of available data streams broadcast to a plurality of mobile devices. The data stream may be, e.g., a high speed downlink packet access (HSDPA) control channel. In the given embodiment, the HSDPA control channel is called a high speed shared control channel (HS-SCCH), and there are up to four (4) broadcast to the mobile device. The object of the invention is to allow the mobile device to quickly and accurately select only one (or none) of the control channels being broadcast thereto.

In step **204,** input symbols are decoded per the decryption relevant to the particular mobile device. If puncture techniques are utilized, input symbols may additionally be de-punctured in step **204.**

In step **206,** the decoder output is re-encoded per the encryption associated with the relevant mobile device. If puncture techniques are utilized, coded symbols may additionally be punctured in step **206.**

In step **208,** the decoded and re-encoded symbol is compared to the originally descrambled received data. In the disclosed embodiments, the sign of the symbols are compared. If they are different, it is an indication that the relevant control channel may not be the proper channel. But, due to a noisy environment, a single symbol comparison may not be dispositive. The more symbols utilized for comparison, the more the environmental conditions are removed from the final selection decision.

In step **210,** if the signs of the compared symbols are different, their magnitudes are accumulated.

In step **212,** a decision is made as to which HS-SCCH is intended to be received by the relevant mobile device. Block **212** selects the HS-SCCH with the minimum metric, but no HS-SCCH is selected in the case that all metrics exceed or otherwise go beyond a given threshold value (step **214**) and all control channels are ignored by the mobile device for the current time period. The value of the threshold may be determined empirically.

Ideally, all available control channels are tested simultaneously, to allow selection of a control channel in the shortest possible time. In this way, for a system including 4 HS-SCCHs, for example, the circuit of Fig. 1 is repeated four times, once for each HS-SCCH control channel. Of course, a serial test of the received control channels is also within the principles of the present invention.

Performance results

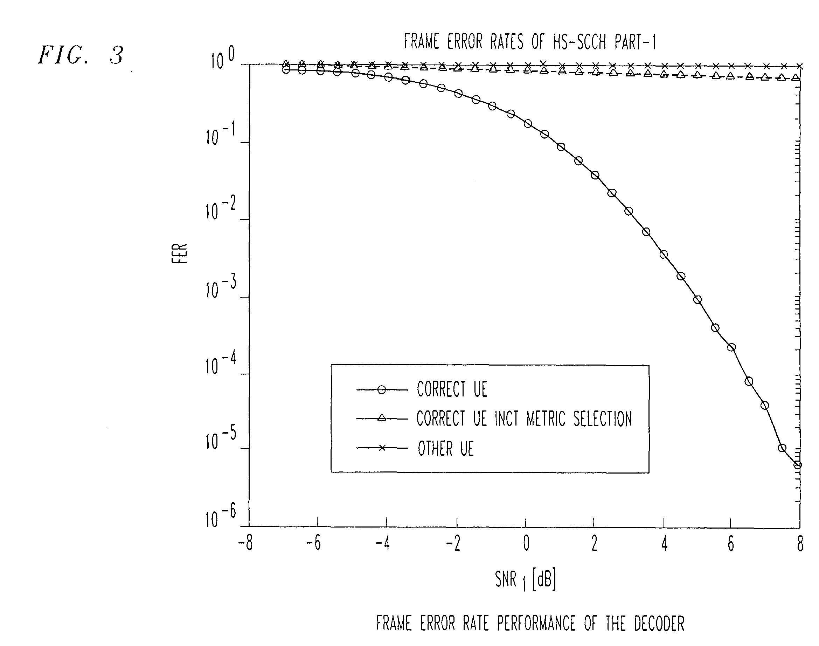

Fig. 3 shows the frame error rate performance of a decoder for Part 1 of the HS-SCCH, in accordance with the principles of the present invention.

In particular, as shown in Fig. 3, data belonging to other UEs (points marked with an 'x') is incorrectly descrambled and may not be properly decoded, yet the data of interest (points marked with circles) is correctly decoded with a markedly improving frame error rate (FER) as signal to noise ratio (SNR) conditions improve.

To determine metrics which provide the most reliable information, five (5) different decoder metrics were implemented. These six decoder metrics are defined as follows:

> Metric 1: Count number of sign differences between re-encoded output and received data.
> Metric 2: Sum magnitude of those received samples that have a different sign to the re-encoded data.
> Metric 3: Sum squared magnitudes of those received samples that have a different sign to the re-encoded data.
> Metric 4: Sum received samples multiplied by sign of the re-encoded data.

Metric 5: Squared Euclidean distance metric (Raw value of zero state metric at end of trellis).

Performance of each of the above metrics was examined to determine how reliable a possible discrimination would be between a correct HS-SCCH and an HS-SCCH belonging to another user in noisy conditions.

In particular, the inventors found, metric 2 to be the most reliable at differentiating between the correct HS-SCCH and an HS-SCCH belonging to another user.

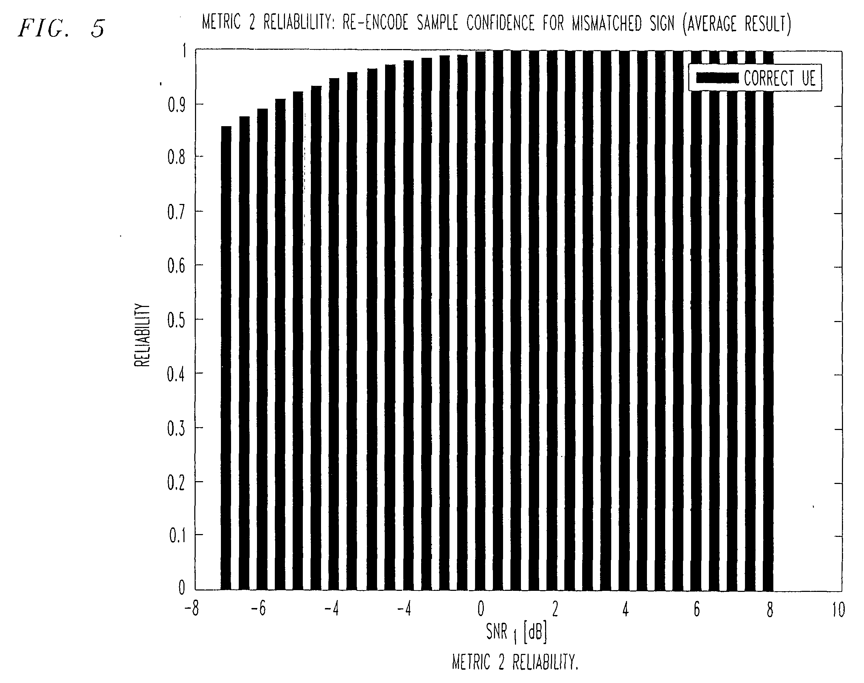

Fig. 5 shows the confirmation of the reliability of techniques using metric 2, by measuring how reliably metric based selection chooses the correctly decoded block.

In particular, as shown in Fig. 5, the reliability of the metric is confirmed by measuring how reliably metric based selection chose the correctly decoded block.

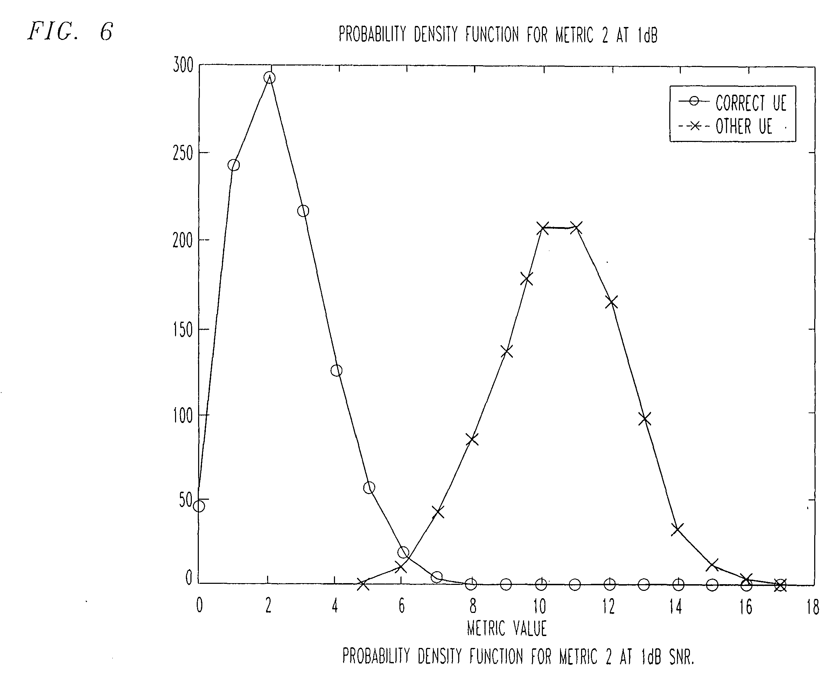

Fig. 6 shows a probability density function for metric 2 with a 1 dB signal-to-noise ratio (SNR). In particular Fig. 6 shows the ability of metric 2 to discriminate between the correct HS-SCCH (left curve) and an incorrect HS-SCCH (right curve).

The effect on overall system performance of making a wrong selection can be seen in Fig. 3 by comparing the Frame Error Rate (FER) for the correct UE including the effect of metric selection (points marked with triangles) with the FER for the intended handset assuming ideal selection (points marked with circles). We observed an almost immeasurable difference between selection based on metric 2 and ideal selection.

Furthermore, metric 2 provides a mechanism to estimate when no HS-SCCH intended for the current UE, despite there being no CRC available. A threshold can be used that allows the determination of cases where no received HS-SCCH is correctly decoded or intended for the current UE and therefore that no HS-SCCH should be selected.

Using a combination of the two above, selection is made for the HS-SCCH block with the minimum metric, provided that metric is below a pre-determined threshold (for example, a threshold of 8 would be useful in the channel conditions simulated (Refer to Fig 6)).

The present invention is very simple to implement in a small digital circuit, providing great advantages over prior art systems. The present invention does not require advance knowledge about the channel (e.g., it doesn't require an estimate of the noise variance). Rather, selection of the block with the minimum metric corresponds to the best block with high reliability. Use of a metric threshold may assist deciding if any HS-SCCH is for the intended UE.

The present invention is particularly applicable to any 3GPP release 5 handset, and may be embedded in an ASIC or firmware, e.g., in a handset's firmware.

While the invention has been described with reference to the exemplary embodiments thereof, those skilled in the art will be able to make various modifications to the described embodiments of the invention without departing from the true spirit and scope of the invention.

**Claims**

**1.** Apparatus to select one of a plurality of scrambled data channels before receipt of an entire data block, comprising:

> a decode module to decode an input symbol from one of said plurality of scrambled data channels;
> a re-encode module to re-encode decoded symbols output from said decode module;
> a comparison module to compare an aspect of a received symbol with a corresponding aspect of said decoded/re-encoded symbol and compute a value as output; and

a decision module to select a best one of said plurality of scrambled data channels based on an accumulated output of said comparison module.

**2.** The apparatus to select one of a plurality of scrambled data channels before receipt of an entire data block according to claim 1, wherein:

said decode module decodes based on an encryption unique to a given mobile device.

**3.** The apparatus to select one of a plurality of scrambled data channels before receipt of an entire data block according to claim 1, wherein:

said aspect is a sign of said symbol.

**4.** The apparatus to select one of a plurality of scrambled data channels before receipt of an entire data block according to claim 1, wherein:

said value is computed as:

$y_i=0$ when *sign(received_sample)*=re-encoded_bit;
$y_i=$ absolute_value(*received_sample*) otherwise.

**5.** The apparatus to select one of a plurality of scrambled data channels before receipt of an entire data block according to claim 3, wherein said decision module comprises:

an accumulator to accumulate outputs from the comparison module.

**6.** The apparatus to select one of a plurality of scrambled data channels before receipt of an entire data block according to claim 1, wherein:

said decoder decodes a received portion of said data block without a benefit of any cyclic redundancy check (CRC) data relevant to said data block.

**7.** The apparatus to select one of a plurality of scrambled data channels before receipt of an entire data block according to claim 1, wherein:

selection can be made using no more than 40 received samples.

**8.** The apparatus to select one of a plurality of scrambled data channels before receipt of an entire data block according to claim 1, wherein:

said plurality of scrambled data channels comprise up to four control channels.

**9.** The apparatus to select one of a plurality of scrambled data channels before receipt of an entire data block according to claim 1, wherein:

said data block is part of a high speed downlink packet access (HSDPA) control channel.

**10.** The apparatus to select one of a plurality of scrambled data channels before receipt of an entire data block according to claim 9, wherein:

said HSDPA control channel is a high speed shared control channel (HS-SCCH)

**11.** The apparatus to select one of a plurality of scrambled data channels before receipt of an entire data block according to claim 1, wherein:

said selection is made prior to complete receipt of an embedded ID in said data channel.

**12.** The apparatus to select one of a plurality of scrambled data channels before receipt of an entire data block according to claim 1, wherein:

said selection is made prior to complete receipt of a cyclic redundancy check (CRC) value.

**13.** The apparatus to select one of a plurality of scrambled data channels before receipt of an entire data block according to claim 1, wherein:

said data channel is scrambled before transmission.

**14.** The apparatus to select one of a plurality of scrambled data channels before receipt of an entire data block according to claim 13, wherein:

said scrambling is dependent upon a unique mask associated with a destination mobile device ID.

**15.** The apparatus to select one of a plurality of scrambled data channels before receipt of an entire data block according to claim 1, wherein:

said data channel is broadcast to multiple mobile devices.

**16.** A method of computing a metric to determine selection of a scrambled data channel before receipt of an entire data block, comprising:

decoding an initial portion of a block of data received in one of a plurality of data channels;

re-encoding said initial portion of said block of data;

computing a value which is related to the number of mis-matched data symbols based on a comparison of decoded/re-encoded data and the corresponding received data; and

selecting a best one of said plurality of data channels based on accumulation of said computed value being beyond a given threshold value.

**17.** The method of computing a metric to determine selection of a scrambled data channel before receipt of an entire data block according to claim 16, wherein:

said computing said value is based upon:

$y_i=0$ when *sign(received_sample)=sign*(re-encoded_bit);
$y_i=$ absolute_value(*received_sample*) otherwise.

**18.** The method of computing a metric to determine selection of a scrambled data channel before receipt of an entire data block according to claim 17, wherein:

said selecting is performed by selecting none of said plurality of data channels.

**19.** The method of computing a metric to determine selection of a scrambled data channel before receipt of an entire data block according to claim 17, wherein:

puncturing and depuncturing is employed by the encoder and decoder to change the code rate.

**20.** Apparatus for computing a metric to determine selection of a scrambled data channel before receipt of an entire data block, comprising:

means for decoding an initial portion of a block of data received in one of a plurality of data channels;
means for re-encoding said initial portion of said block of data;
means for computing a value related to the number of mis-matched data symbols based on a comparison of decoded/re-encoded data and the corresponding received data; and
means for selecting a best one of said plurality of data channels based on accumulation of said computed value being beyond a given threshold value.

**21.** The apparatus for computing a metric to determine selection of a scrambled data channel before receipt of an entire data block according to claim 20, wherein:

said means for computing said value bases said value on a comparison of symbol signs and symbol magnitude.

**22.** The apparatus for computing a metric to determine selection of a scrambled data channel before receipt of an entire data block according to claim 20, wherein:

said means for selecting performs said selection by selecting none of said plurality of data channels.

**22.** The apparatus for computing a metric to determine selection of a scrambled data channel before receipt of an entire data block according to claim 20, wherein:

selection can be made using no more than 40 received samples.

FIG. 1

*FIG. 2*

START

DESCRAMBLE INPUT SAMPLES PER RELEVANT DEVICE ID — 202

DECODE — 204

RE-ENCODE — 206

COMPARE SIGN OF RE-ENCODED SYMBOLS WITH SIGN OF DESCRAMBLED INPUT SIGNALS — 208

ACCUMULATE MAGNITUDES OF APPLICABLE INPUT SAMPLES — 210

REPEAT FOR EACH CONTROL CHANNEL RECEIVED

SELECT BEST HS-SCCH INTENDED FOR UE BASED ON VALUES FROM ACCUMULATOR — 212

214 — EXCEED THRESHOLD?

YES → DISCARD, SELECT NONE

NO

END

FIG. 3

FRAME ERROR RATES OF HS-SCCH PART-1

FER

CORRECT UE

CORRECT UE INCT METRIC SELECTION

OTHER UE

SNR $_1$ [dB]

FRAME ERROR RATE PERFORMANCE OF THE DECODER

EP 1 717 983 A1

FIG. 4

METRIC 2: RE-ENCODE MAIN INPUT SAMPLE CONFIDENCE
FOR MISMATCHED SIGN (AVERAGE RESULT)

METRIC 2 RESULTS (AVERAGE CASE).

EP 1 717 983 A1

FIG. 5

METRIC 2 RELIABLILITY: RE-ENCODE SAMPLE CONFIDENCE FOR MISMATCHED SIGN (AVERAGE RESULT)

METRIC 2 RELIABILITY.

FIG. 6

PROBABILITY DENSITY FUNCTION FOR METRIC 2 AT 1dB

PROBABILITY DENSITY FUNCTION FOR METRIC 2 AT 1dB SNR.

EP 1 717 983 A1

**EP 1 717 983 A1**

**European Patent Office**

**EUROPEAN SEARCH REPORT**

Application Number

EP 06 25 0632

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/001428 A1 (DATTA SUPARNA ET AL) 1 January 2004 (2004-01-01) * paragraph [0018] * * paragraph [0021] * * paragraph [0027] * * paragraph [0033] * ----- | 1-23 | H04L1/00 H03M13/37 |
| A | EP 1 487 118 A (LUCENT TECHNOLOGIES INC) 15 December 2004 (2004-12-15) * paragraph [0007] - paragraph [0015] * * paragraph [0031] * * paragraph [0042] * ----- | 1-23 | |
| A | "Performance of the HS-SCCH" 3GPP TSG RAN WG1 #25, 12 April 2002 (2002-04-12), pages 1-12, XP002301041 * sections 1 and 2 * ----- | 1-23 | |
| A | YIQUN GE ET AL: "Design space exploration of HSDPA subsystem algorithms and architectures" VEHICULAR TECHNOLOGY CONFERENCE, 2004. VTC 2004-SPRING. 2004 IEEE 59TH MILAN, ITALY 17-19 MAY 2004, PISCATAWAY, NJ, USA,IEEE, US, vol. 3, 17 May 2004 (2004-05-17), pages 1246-1250, XP010766341 ISBN: 0-7803-8255-2 * page 1246, left-hand column, paragraph 1 - right-hand column, last paragraph * ----- | 1-23 | TECHNICAL FIELDS SEARCHED (IPC) H04L H03M |

The present search report has been drawn up for all claims

| Place of search | Date of completion of the search | Examiner |
|---|---|---|
| Munich | 30 March 2006 | Agudo Cortada, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 25 0632

This annex lists the patent family members relating to the patent documents cited in the above-mentioned European search report.
The members are as contained in the European Patent Office EDP file on
The European Patent Office is in no way liable for these particulars which are merely given for the purpose of information.

30-03-2006

| Patent document cited in search report | | Publication date | Patent family member(s) | | Publication date |
|---|---|---|---|---|---|
| US 2004001428 | A1 | 01-01-2004 | NONE | | |
| EP 1487118 | A | 15-12-2004 | EP | 1487119 A2 | 15-12-2004 |
| | | | EP | 1487120 A2 | 15-12-2004 |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Performance of the HS-SCCH. 3GPP TSG-RAN WG1#24, R1-02-0610. Motorola, April 2002
- Way forward on HS-SCCH coding. 3GPP TSG-RAN WG1#25, R1-02-0553. Lucent Technologies, April 2002
- Performance of the HS-SCCH. 3GPP TSG-RAN WG1#25, R1-02-0649. Lucent Technologies, April 2002
- **GHOSH ; RATASUK ; FRANK ; LOVE ; STEWART ; BUCKLEY.** Control Channel Design for High Speed Downlink Shared Channel for 3GPP W-CDMA, Rel-5. *Vehicular Technology Conference 2003 (VTC '03,* April 2003
- **DAS ; GOPALAKRISHNAN ; HU ; KHAN ; RUDRAPATNA ; SAMPATH ; SU ; TATESH ; ZHANG.** Evolution of UMTS Toward High-Speed Downlink Packet Access. *Bell Labs Technical Journal,* 2003, vol. 7 (3), 47-68

- **BERNS, F. ; KREISELMAIER, G ; WHEN, N.** Channel decoder architecture for 3G mobile wireless terminals. *Design, Automation and Test in Europe Conference and Exhibition, 2004. Proceedings,* 16 February 2004, 192-197
- **AHMED, W.K.M. ; BALACHANDRAN, K.** Methods for estimation of the uncoded symbol error rate at the receiver. *Global Telecommunications Conference, 2002. GLOBECOM '02. IEEE,* 17 November 2002, 1334-1338
- **RAGHAVAN, A.R. ; BAUM, C.W.** A reliability output Viterbi algorithm with applications to hybrid ARQ. *IEEE Trans.Information Theory,* May 1998, vol. 44 (3), 1214-1216